Europäisches Patentamt

European Patent Office

Office européen des brevets

(19)

(11) Veröffentlichungsnummer: **0 285 915**

**A2**

(12) **EUROPÄISCHE PATENTANMELDUNG**

(21) Anmeldenummer: **88104712.0**

(22) Anmeldetag: **24.03.88**

(51) Int. Cl.⁴: **H03K 17/97**

(30) Priorität: **04.04.87 DE 3711484**

(43) Veröffentlichungstag der Anmeldung:
**12.10.88 Patentblatt 88/41**

(84) Benannte Vertragsstaaten:
**AT CH DE ES FR GB IT LI NL SE**

(71) Anmelder: **Braun Aktiengesellschaft**
**Rüsselsheimer Strasse 22**
**D-6000 Frankfurt/Main(DE)**

(72) Erfinder: **Meyer, Werner**
**Frankfurter Strasse 25**
**D-6231 Schwalbach(DE)**

(54) **Betätigungseinrichtung für ein elektrisches Gerät.**

(57) Es wird eine Betätigungseinrichtung für ein elektrisches Gerät, insbesondere für elektrische Kleingeräte wie Zahnbürsten, Mundduschen, Haartrockner, Lockenstäbe, Rasierapparate, und Küchenmaschinen, zum Steuern oder Regeln wenigstens einer Betriebsgröße mit einem Signalgeber zur Erzeugung von Steuergrößen und einer Schaltungsanordnung beschrieben. Die Betätigungseinrichtung zeichnet sich dadurch aus, daß der Signalgeber ein bewegbares, an dem elektrischen Gerät angeordnetes Element, welches in Abhängigkeit von seiner Positionierung magnetische oder elektrische Felder unterschiedlicher Feldstärke bewirkt, und ein auf magnetische oder elektrische Felder empfindliches, stationär am elektrischen Gerät angeordnetes Element aufweist. Das feldempfindliche Element erzeugt eine Ausgangsgröße, die ein Maß für die Feldstärke am Ort des feldempfindlichen Elementes ist, die Ausgangsgröße ist der Schaltunganordnung zuführbar und die Schaltungsanordnung beinhaltet wenigstens eine Steuerfunktion, die ihrerseits die Betriebsgröße des elektrischen Gerätes beeinflußt.

FIG.2

## Betätigungseinrichtung für ein elektrisches Gerät

Zur Bedienung elektrischer Geräte ist es häufig erforderlich, eine Betätigungseinrichtung vorzusehen, die mittels eines Signalgebers und einer nachgeschalteten Schaltungsanordnung eine Variation wenigstens einer Betriebsgröße des elektrischen Gerätes erlauben. Bereits aus der DE-OS 28 48 749 ist eine Betätigungseinrichtung nach der Gattung des Hauptanspruchs bekannt. Die Betätigungseinrichtung besteht aus einem Mehrstufenschalter und einer Spule, die Bestandteil des Transformators einer Ladenschaltung ist. Zur Drehzahlregulierung kann diese Spule über eine Anzapfung mittels des mehrstufigen Schalters wahlweise in einen Stromkreis eines Motors einer elektrischen Zahnbürste eingeschaltet werden. Diese Betätigungseinrichtung gestattet lediglich das Einstellen von fest vorgegebenen einzelnen Drehzahlwerten, aber nicht eine kontinuierliche Einstellung der Drehzahl. Weiterhin ist es in der Praxis recht problematisch, Schalter für deratige Einsatzzwecke bei Zahnbürsten, Mundduschen, elektrischen Haushaltsgeräten, Rasierapparaten und ähnlichem zu realisieren, da zum Schutze des Benutzers derartiger Geräte, wie auch zur Gewährleistung einer sicheren Funktionsweise des Gerätes derartige Schalter zum einen wasserdicht oder wassergeschützt sein sollten und zum anderen ein Eintritt von Feuchtigkeit oder Wasser in das Innere des Gehäuses des elektrischen Gerätes vermieden werden sollte.

Der Erfindung liegt daher die Aufgabe zugrunde, eine gattungsgemäße Betätigungseinrichtung für elektrische Geräte derart weiterzuentwickeln, daß über eine einzige, bewegliche Steuervorrichtung am Gehäuse des elektrischen Gerätes eine kontinuierliche Steuerung oder Regelung wenigstens einer Betriebsgröße des Gerätes möglich ist. Gleichzeitig soll eine hohe Betriebssicherheit für den Benutzer gewährleistet und die Funktionsfähigkeit der Stelleinrichtung nicht durch äußere Einflüsse wie Feuchtigkeit und Schmutz beeinträchtigt sein.

Die Aufgabe wird durch eine Betätigungseinrichtung mit dem Merkmalen des Hauptanspruchs gelöst.

Durch diese Maßnahmen ist eine weitgehend beliebige Einstellung einer Betriebsgröße des elektrischen Gerätes unter Verwendung eines einzigen bewegbaren Signalgebers möglich. Gleichzeitig ist auch eine hohe Betriebs-und Funktionssicherheit gewährleistet, da zwischen dem feldbeeinflussenden bzw. felderzeugenden Element und dem feldempfindlichen Element keine körperlichen Verbindungen erforderlich sind. Das felderzeugende bzw. feldbeeinflussende Element ist von beispielsweise einem Benutzer des Gerätes betätigbar und beeinflußt das beispielsweise im Gerätgehäuse stationär angeordnete feldempfindliche Element, ohne daß mechanische Verbindungen oder elektrische Leitungen zwischen beiden Elementen erforderlich wären. Dennoch läßt sich die Betriebsgröße des elektrischen Gerätes über eine Auswertung der Ausgangsgröße des feldemfindlichen Elements feinfühlig und weitestgehend kontinuierlich einstellen bzw. regeln.

Dadurch, daß die Schaltungsanordnung eine Schwellwertfunktion und bzw. oder eine proportionale Funktion aufweist, kann die Betriebsgröße des elektrischen Gerätes mit einem einzigen bewegbaren Element an-bzw. abgeschaltet und gleichzeitig auf vorgegebene Werte eingestellt werden, ohne daß mechanische Rastpunkte an dem beweglichen Element vorzusehen sind.

Eine Ausbildung des bewegbaren Elements als Permanentmagnet bzw. als Rückschlußbügel eines Permanentmagnets und des feldempfindlichen Elements als Feldplattes beinhaltet den Vorteil einer kostengünstigen Großserienfertigung und einer kompakten Bauweise, da solchermaßen ausgestaltete Elemente klein im Aufbau und relativ preisgünstig herstellbar sind. Durch eine Anordnung der Feldplatte und der Schaltungsanordnung im Innenraum eines Gehäuses des elektrischen Gerätes und des bewegbaren Elements im äußeren Bereich des Gehäuses des elektrischen Geräts wird das Gerätegehäuse an sich in seiner Funktion als Isolation gegen Feuchtigkeit, Schmutz und elektrische Spannungen voll wirksam. Darüber hinaus ist das Gehäuse ohne die ansonsten erforderlichen Durchbrechungen für herkömmliche Schalter oder Potentiometer wesentlich einfacher und kostengünstiger herstellbar.Weitere vorteilhafte Ausgestaltungen der Schaltungsanordnung zur Verarbeitung der Signale des Signalgebers ergeben sich aus den Unteransprüchen in Verbindung mit der Beschreibung der Ausführungsfbeispiele.

Als besonders vorteilhaft erweist sich eine Ausbildung der Schaltungsanordnung als Regelkreis zur Regelung der Betriebsgröße des elektrischen Gerätes. Obwohl das Signal zur Festlegung des Einschaltpunktes der Betriebsgröße des Gerätes und das Signal, das zur weitgehend kontinuierlichen Einstellung der Betriebsgröße herangezogen wird, aus einem einzigen Ausgangssignal, nämlich dem Ausgangssignal des Signalgebers abgeleitet werden, ist durch die spezielle, in den Ansprüchen angegebene Ausgestaltung des Regelkreises eine Regelung der Betriebsgröße möglich. Mit der Ausbildung der Koppelfunktion vorzugsweise als Widerstand, ist eine sehr kostengünstige, aber dennoch effektive Maßnahme zur Realisierung der Koppelfunktion angegeben.

Durch eine Anordnung des feldempfindlichen Elements auf einem Polschuh eines Permanentmagneten, wobei durch das bewegbare Element der das feldempfindliche Element durchsetzende Fluß variierbar ist und durch eine bevorzugte Ausbildung des bewegbaren Elements, des Polschuhs und des Premanentmagneten als Schalensegmente, die konzentrisch um eine Gehäuseachse angeordnet sind, ergibt sich eine optimale Anpassung der Betätigungseinrichtung und Raumausnutzung für den Einsatz bei im wesentlichen zylindrisch geformten Gehäusen von elektrischen Geräten. Insbesondere die Gestaltung des Polschuhs als Kreisringabschnitt mit daran anschließendem Winkelabschnitt, dessen fußförmiges freies Ende insbesondere eine Feldplatte trägt, erweist sich als äußerst vorteilhaft, da der magnetische Kreis nur geringe magnetisch wirksame Widerstände, wie Luftspalten u.ä. aufweist und somit das feldempflindliche Element stets ausreichenden Felstärken ausgesetzt und eine befriedigende Auflösung gewährleistet ist. Weitere vorteilhafte Ausgestaltungen der mechanischen Ausbildung des Signalgebers, auch zur Steuerung oder Regelung von mehr als einer Betriebsgröße, sind in den Unteransprüchen sowie in der Beschreibung der Ausführungsbeispiele angegeben.

Es zeigen:

Fig. 1 A einen Signalgeber mit einer Feldplatte;

Fig. 1 B ein Kennliniendiagramm der Feldplatte aus Fig. 1 A;

Fig. 2 ein Ausführungsbeispiel einer Betätigungseinrichtung;

Fig. 3 eine Prinzipschaltung eines ersten Ausführungsbeispiels einer Schaltungsanordnung;

Fig. 4 eine Prinzipschaltugn eines zweiten Ausführungsbeispiels einer Schaltungsanordnung;

Fig. 5 A ein detailliertes Schaltungsdiagramm zu der Prinzipschaltung gemäß Fig. 4;

Fig. 5 B ein Impulsdiagramm zur Erläuterung der Funktionsweise der Schaltung gemäß Fig. 5 A;

Fig. 6 ein erstes Ausführungsbeispiel eines Signalgebers im Querschnitt;

Fig. 7 eine schematische Ansicht eines zweiten Ausführungsbeispiels eines Signalgebers in perspektivischer Darstellung;

Fig. 8 eine perspektivische Ansicht eines dritten Ausführungsbeispiels eines Signalgebers mit runder Grundform;

Fig. 9 ein viertes Ausführungsbeipsiel eines Signalgebers mit runder Grundform;

Fig. 10 eine perspektivische Ansicht eines fünften Ausführungsbeispiels mit einer ebenen Grundform.

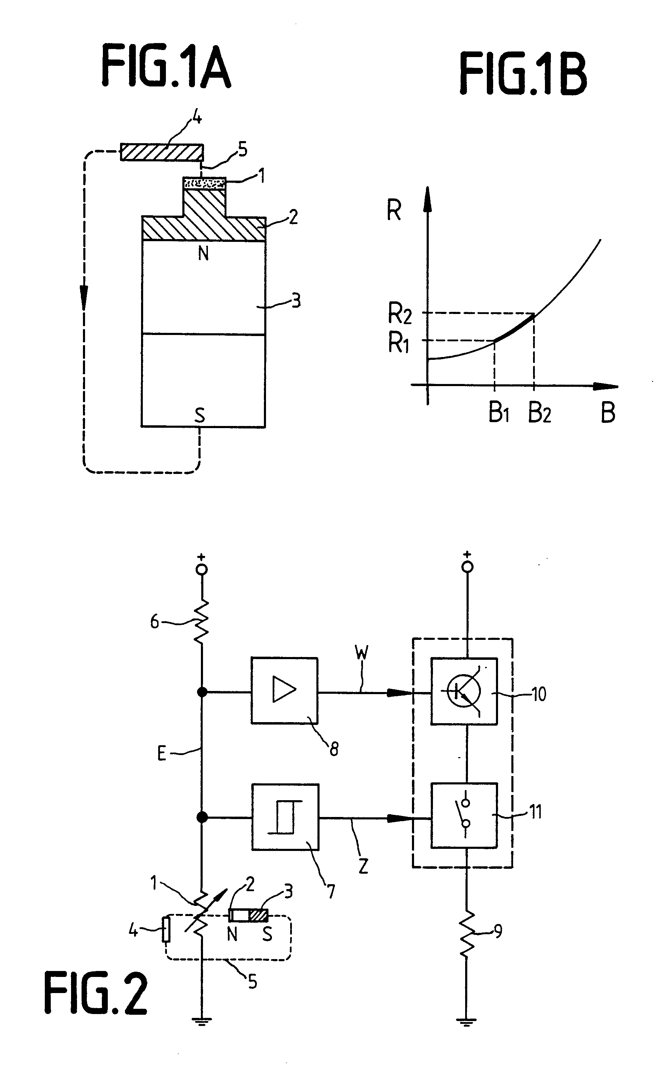

Fig. 1 A zeigt eine an sich bekannte Feldplatte 1 mit einem Polschuh 2 aus Weicheisenmaterial, einem Permanentmagneten 3 und einem bewegbaren Element 4. Auf dem Polschuh 2 ist die Feldplatte dem magnetischen Streufluß 5 ausgesetzt, der von dem Permanentmagneten 3 herrührt. Mittels des Elements 4, das bezüglich der Feldplatte 1 verschiebbar angeordnet ist, läßt sich der die Feldplatte 1 durchsetzende magnetische Streufluß 5 variieren. Wie in Fig. 1 B dargestellt, bewirkt eine Änderung der die Feldplatte 1 durchsetzenden magnetischen Induktion B eine Änderung des widerstandes R der Feldplatte 1. Somit äußert sich eine Positionsänderung des Elements 4 in einer Widerstandsänderung des Feldplattenwiderstandes.

Fig. 2 zeigt ein Ausführungsbeispiel einer Betätigungseinrichtung eines elektrischen Gerätes. Der Signalgeber ist z.B. an einem Handstück oder an einem Gehäuse angeordnet und weist die bereits in Fig. 1 A beschriebenen Teile auf. In Fig. 2 ist die Feldplatte 1 als veränderlicher elektrischer Widerstand dargestellt, da es für die Erläuterung gerade der Schaltungsanordnung nur hierauf ankommt.

Zur Feldplatte 1 ist ein Widerstand 6 in Serie geschaltet, wobei diese Serienschaltung zwischen den beiden Polen einer Versorgungs-Gleichspannung angeschlossen ist. An einem Mittelabgriff dieser Serienschaltung liegt ein elektrisches Signal E an, welches ein Maß für den Widerstandswert der Feldplatte 1 und damit für die Positionierung des bewegbaren Elements 4 ist. Das Signal E ist an die Eingänge einer Schaltungsanordnung angeschlossen, die eine Proportionalfunktion 8 und eine Schwellwertfunktion 7 aufweist. Die Realisierung derartiger Funktionen ist zum Beispiel dem Standdardwerk "Halbleiter-Schaltungstechnik" von U. Tietze und Ch. Schenk, Springer Verlag Berlin, Heidelberg, New Yor, 5. Auflage, insbesondere Seite 411 ff. und Seite 688 ff. zu entnehmen.

Ein Ausgangssignal W der Proportionalfunktion 8 wird einer Steuerfunktion 10 zugeführt, die in Reihe mit einer Schaltfunktion 11 und einem Verbraucher 9 zwischen die Pole der Versorgungsspannung geschaltet ist. Die Schaltfunktion 11 wird von Ausgangssignalen Z der Schwellwertfunktion 7 angesteuert. Als Verbraucher 9 kommt je nach Art des elektrischen Gerätes beispielsweise ein Elektromotor, eine elektrische Heizung oder ähnliches in Frage, wobei unter der zu steuernden bzw. zu regelnden Betriebsgröße dann die Drehzahl des Elektromotors oder die Heizleistung der Heizung zu verstehen ist. Durch die Steuerfunktion 10 läßt sich die Leistung des Verbrauchers 9 kontinuierlich in Abhängigkeit von dem Signal W steuern, während durch die Schaltfunktion 11 in Abhängigkeit vom Signal Z ein EIN/AUS-Schalten des Verbrauchers 9 möglich ist.

Diese Betätigungseinrichtung dient somit zum Einstellen und zum EIN/AUS-Schalten einer Betriebsgröße eines elektrischen Gerätes, das einen beispielsweise handbetätigbaren Signalgeber aufweist. Vorteilhafterweise wird der Einschaltpunkt des Gerätes bzw. der Betriebsgröße und die Variation der Betriebsgröße mit einem einzigen beweglichen Element 4 durchgeführt. Als vorteilhaft erweist sich, daß ein Ausschalten des Gerätes nur unter Zurückstellen der Betriebsgröße auf kleine Werte möglich ist. Umgekehrt ist ein Einschalten des Gerätes bei maximalen Werten der Betriebsgröße nicht möglich, etwa ein Einschalten des Gerätes bei maximaler Drehzahl. Handelt es sich bei dem Verbraucher 9 beispielsweise um einen Gebläsemotor oder eine Heizung eines Haartrockners, läßt sich die Gebläse-bzw. Heizleistung mit der in Fig. 2 gezeigten Schaltung z.B. leicht mit einem Finger einer Hand einschalten und variieren.

Wird das Element 4 so positioniert, daß die magnetische Induktion zunimmt, steigt die Ausgangsspannung (Signal E) des Signalgebers an. Ist der Einschaltpunkt der Schwellwertfunktion 7 erreicht, wird die Schaltfunktion 11 auf EIN geschaltet. Eine weitere Bewegung des Elements 4 läßt das Signal E weiter ansteigen, so daß die Steuerfunktion 10 eine größere Leistungszufuhr zu dem Verbraucher 9 zuläßt. Somit kann die Betriebsgröße des Gerätes über das bewegbare Element 4, die Proportionalfunktion 8 und die Steuerfunktion 10 auf einen größeren oder niedrigen Werte eingestellt werden. Die Schaltfunktion 11 bleibt währenddessen im EIN-Zustand und übt keinen weiteren Einfluß auf die Leistungszufuhr aus.

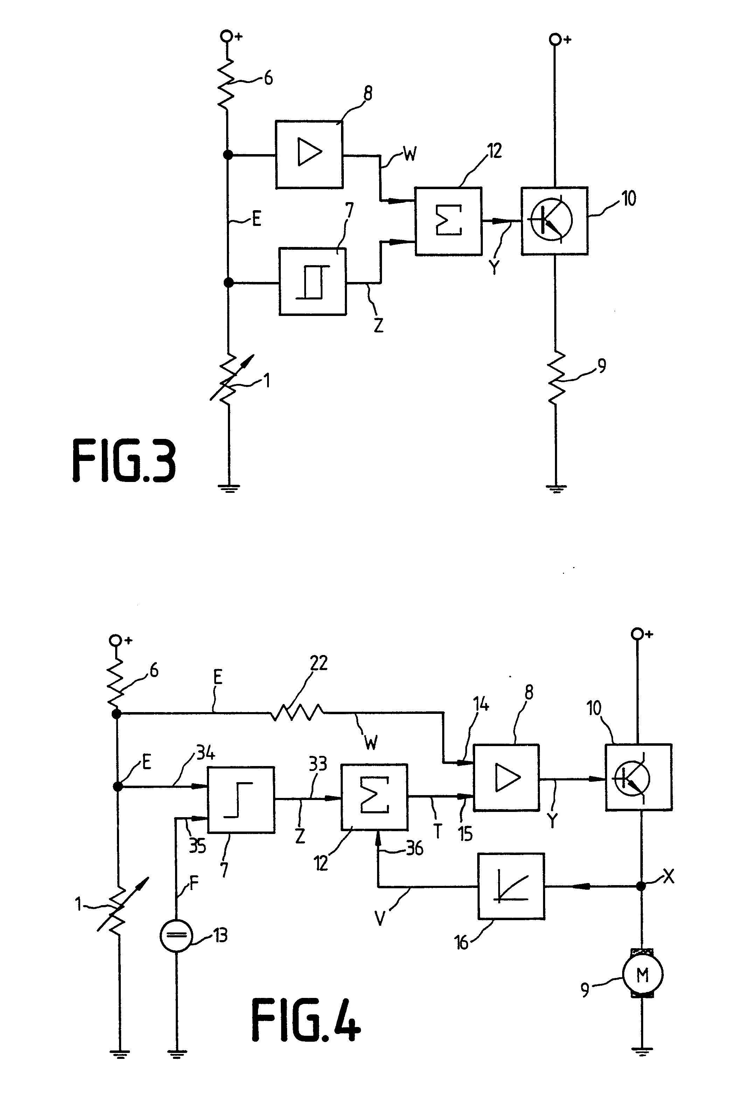

Wird das Element 4 zurückbewegt und der Ausschaltpunkt erreicht, so unterbricht die Schwellwertfunktion 7 über die Schaltfunktion 11 ein weiteres Verändern der Betriebsgröße des elektrischen Gerätes und schaltet den Verbraucher 9 aus. Das Einschalten und die Variation der Betriebsgröße des elektrischen Gerätes lassen sich äußerst feinfühlung z. B. mit einem einzigen Finger durch den Benutzer durchführen. Die Proportionalfunktion 8 kann entfallen, wenn das Ausgangssignal E des Signalgebers ausreicht, die Steuerfunktion 10 direkt anzusteuern. Der Einschaltpunkt, zu dem die Betriebsgröße des elektrsichen Gerätes kontinuierlich variiert werden soll, läßt sich durch Einstellen des Schwellwertes der Schwellwertfunktion 7 festlegen. Dadurch entfallen aufwendige mechanische Justierarbeiten, um exakte und unterschiedliche Einschaltpunkte zu bestimmen, so daß die Schaltungsanordnung universell einsetzbar ist. In Fig. 2, wie in den nachfolgenden Figuren 3 bis 5 kann es sich bei der Schwellwertfunktion 7 um einen Schnitt-Trigger oder Komparator handeln.

Fig. 3 zeigt ein erstes Ausführungsbeispiel einer Schaltungsanordnung, wobei zu Fig. 2 identische Teile mit den gleichen Bezugsziffern bezeichnet sind. Der Signalgeber ist in Fig. 3 rein - schematisch durch den Widerstand der Feldplatten 1 dargestellt.

Abweichend von der Schaltungsanordnung in Fig. 2 werden die beiden Ausgangssignale W und Z der Schwellwertschaltstufe 7 und der verstärkerstufe 8 einer Koppelfunktion 12 zugeführt, deren Ausgangssignal die Steuerfunktion 10 zur Variation und zum EIN/AUS-Schalten der Betriebsgröße ansteuert. Die Steuerfunktion 10 besteht beispielsweise aus einem Leistungstransistor, der den Stromzufluß durch den Verbraucher 9 in Abhängigkeit von einem Signal Y am Ausgang der Koppelfunktion 12 steuert. Die Koppelfunktion kann z.B. durch einen als Addierer bzw. Subtrahierer beschalteten Operationsverstärker oder eine Diodengatterschaltung realisiert werden (siehe auch "Halbleiterschaltungstechnik" S. 189 ff., 147 ff.)

Nach dem Ausführungsbeispiel der Fig. 3 wird ein Transistor der Steuerfunktion 10 gleichzeitig als Schalter und kontinuierlich wirkendes Steuerorgan eingesetzt. Die Wirkung der Schaltungsanordnung ist wie folgt: Das Ausgangssignal Y der Koppelfunktion 12 versetzt den Transistor der Steuerfunktion 10 immer dann in den Sperrzustand, wenn das Ausgangssignal Z der Schwellwertfunktion 7 Werte annimmt, die infolge der spezifischen Widerstandseinstellung der Feldplatte 1 den AUS-Zustand für die zu steuernde Betriebsgröße darstellen. Dies erfolgt unabhängig von der am zweiten Eingang der Koppelfunktion 12 jeweils anliegenden Ausgangsgröße W der Proportionalfunktion 8. Springt das Ausgangssignal Z infolge einer Widerstandsänderung der Feldplatte 1 auf Werte, die den EIN-Zustand der Betriebsgröße signalisieren, wird am Ausgang der Koppelfunktion 12 ein zum Ausgangssignal W der Proportionalfunktion 8 proportionales Signal Y wirksam, das den Transistor der Steuerfunktion 10 mehr oder weniger aus dem Sperrzustand in den Durchlaß-Zustand steuert.

Fig. 4 zeigt ein weiteres Ausführungsbeispiel einer Schaltungsanordnung mit einem Regelkreis, bei dem zu den vorherigen Ausführungsbeispielen gleiche Teile mit gleichen Bezugsziffern bezeichnet sind. Der Regelkreis wird durch die Steuerfunktion 10, eine Rückführungsfunktion 16, die Koppelfunktion 12 und die Proportionalfunktion 8 gebildet. Die Proportionalfunktion 8 weist einen ersten Eingang 14 und einen zweiten Eingang 15 auf. Der erste Eingang 14 der Proportionalfunktion 8 wird über einen Widerstand 22 mit dem am Mittelabgriff des Spannungsteilers anliegenden Signal E beaufschlagt. Der Widerstand 22 kann gegebenenfalls entfallen, wobei dann das Signal E dem Signal W entspricht.

Zur Erläuterung der Funktionsweise des Regelkreises sei zunächst angenommen, daß die Koppelfunktion keinen Einfluß auf den Regelkreis ausübt und das Signal V am Ausgang der Rückführungsfunktion 16 mit dem Signal T am Eingang 15 der Proportionalfunktion 8 identisch ist. Die Regelgröße X, die ein Maß für den Wert der zu regelnden Betriebsgröße, zum Beispiel der Drehzahl eines Gleichstrommotors darstellt, wird über die Rückführungsfunktion 16, die P-oder I-oder D-Verhalten oder eine Kombination aufweisen kann, dem zweiten Eingang 15 der Proportionalfunktion 8 zugeführt. In der Proportionalfunktion 8 findet ein Vergleich zwischen dem Signal W und dem Signal T statt, wobei das Ergebnis dieses Vergleichs durch das Signal Y (Stellgröße) am Ausgang der Proportionalfunktion 8 anliegt und die Steuerfunktion 10 entspechend beeinflußt. Schwankungen beispielsweise der Drehzahl eines Gleichstrommotors bzw. der Heizleistung einer Heizung wird durch diesen Regelkreis entgegengewirkt, wobei die Positionierung des bewegbaren Elements 4 der Betätigungseinrichtung den Führungswert der Betriebsgröße bestimmt. Neben der Regelung beispielsweise der Gebläse-oder Heizleistung eines Haartrockners kann beispielsweise auch die Schnittgewschwindigkeit eines Trockenrasierers, der Wasserstrahldruck einer Munddusche oder die Drehzahl einer Antriebseinheit einer Küchenmaschine auf die dargestellt Weise gesteuert oder geregelt werden.

Unter Berücksichtigung des Einflusses der bisher aus den Betrachtungen ausgeschlossenen Schwellwertfunktion 7 ergeben sich folgende Modifikationen: Signalisiert die Schwellwertfunktion 7 den EIN-Zustand der Betriebskenngröße - dies ist beispielsweise dann der Fall, wenn das Signal E den Wert F einer Referenzsignalquelle 13 überschreitet - so liefert der Ausgang der Schwellwertfunktion 7 ein Signal Z, welches ohne Einfluß auf das Ausgangssignal T der Koppelfunktion 12 ist, so daß die Funktion des Regelkreises somit nicht durch Signale der Schwellwertfunktion 7 beeinflußt wird. Befindet sich dagegen das bewegbare Element 4 in einer Position, die dem AUS-Zustand entspricht, dann bewirkt die am Ausgang der Schwellwertfunktion 7 anliegende Signalgröße Z ein Sperren des Transistors der Steuerfunktion 10. Regelungstechnisch kann das Ausgangssignal Z der Schwellwertfunktion 7 auch als in den Regelkreis eingekoppeltes Störsignal aufgefaßt werden, welches den AUS-Zustand der Steuerfunktion 10 sicher und unabhängig vom Wert des Signals W bewirkt.

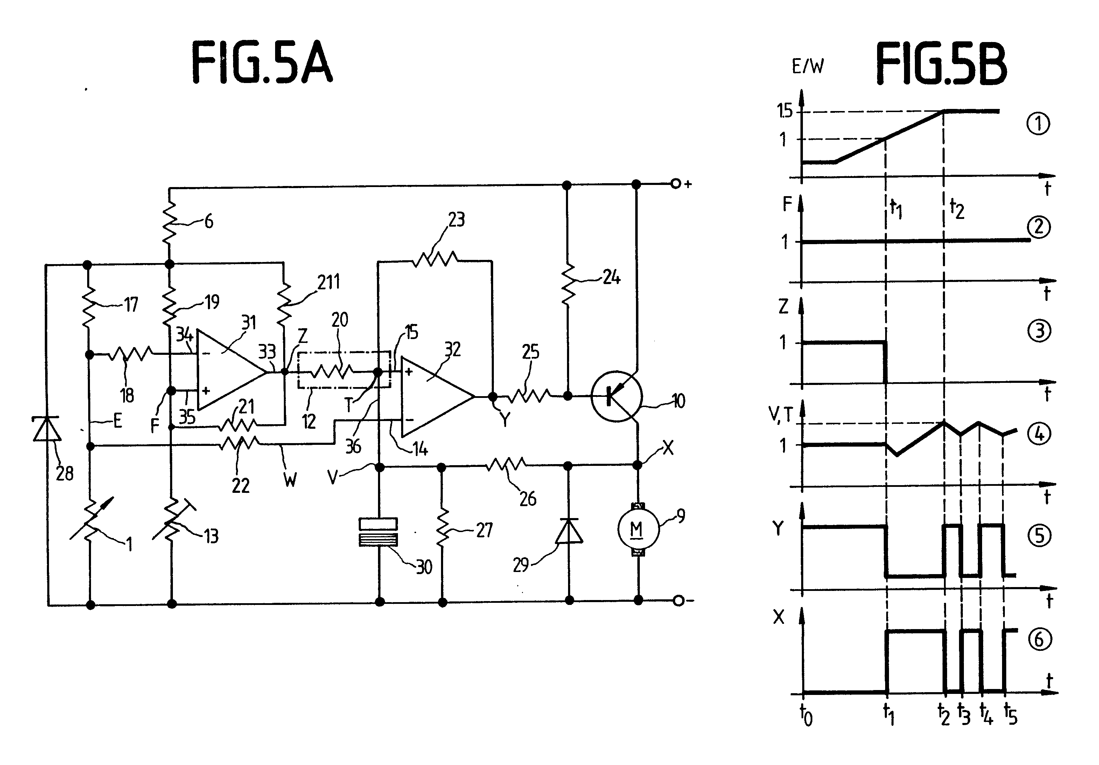

Fig. 5A zeigt ein detailliertes Ausführungsbeispiel eines Schaltungsdiagramms entsprechend dem Blockschaltbild der Fig. 4. Die Schwellwertfunktion 7 der Fig. 4 weist einen ersten als Komparator beschalteten Operationsverstärker 31 auf, dem über einen Widerstad 18 an einem ersten Eingangsanschluß 34 das Ausgangssignal E des Signalgebers zugeführt wird. Wie bereits dargestellt, liegt die Feldplatte 1 in Serie mit einem Widerstand 17. Der Mittelabgriff der Serienschaltung eines Stellwiderstandes 13 und eines Vorwiderstandes 19 ist mit einem zweiten Eingang 35 des Komparators 31 verbunden. Die Widerstände 17, 19 sind über einen Widerstand 6 mit einem Pluspol der Versorgungsspannung verbunden. Ein Widerstand 21 verbindet als Rückkopplungswiderstand einen Ausgang 33 des Komparators 31 mit dem Eingang 35. Weist der Komparator 31 einen "Open Collector"-Ausgang 33 auf, so ist ein Widerstand 211 zwischen dem Ausgang 33 und einem Verbindungspunkt der Widerstände 6, 19 vorgesehen. Den Widerständen 17, 1 bzw. 19, 13 ist eine Zenerdiode 28 parallel geschaltet, die in Verbindung mit dem Widerstand 6 eine Spannungsstabilisierung bewirkt. Über den Stellwiderstand 13 läßt sich der Wert der Referenzspannung F an dem zweiten Komparatoreingang 35 einstellen. Die Referenzspannung F bestimmt den EIN/AUS-Schaltpunkt bzw. den Übergangspunkt, ab dem der Wert der Betriebsgröße kontinuierlich einstellbar ist. Die Verstärkerstufe 8 besteht im vorhergehenden Ausführungsbeispiel aus einem Operationsverstärker 32, dessen ersten Eingang 14 das Signal W als Führungsgröße und dessen zweiten Eingang 15 das Ausgangssignal T der Koppelfunktion 12 zugeführt wird.

Die Koppelfunktion 12 besteht vorzugsweise aus einem einzigen Widerstand 20, der zwischen dem Ausgang 33 und dem Eingang 15 geschaltet ist. In vorteilhafter Weise wird das Rückführungssignal V am Eingang 15 dem Ausgangssignal T des Widerstandes 20 überlagert. Der zeite Operationsverstärker 32 weist einen Rückkopplungswiderstand 23, der vom Ausgang auf den zweiten Eingangsanschluß 15 geschaltet ist auf und ist über einen Widerstand 25 ausgangsseitig mit der Steuerfunktion 10 verbunden.

Die Steuerfunktion 10 besteht aus einem PNP-Transistor, dessen Basis über einen Widerstand 24 mit einem Pluspol der Versorgungsspannung und mit Widerstand 25 verbunden ist. Der Emitter des Transistors ist direkt an den Pluspol der Versorgungspannung angeschlossen. Kollektorseitig ist der Transistor an den Verbraucher 9, im vorliegenden Ausführungsbeispiel ein Gleichstrommotor, angeschlossen, der mit seinem zweiten Anschluß mit einem Minuspol der Versorgungsspannung verbunden ist.

Die Rückführungsfunktion 16 wird durch eine Diode 29, Widerstände 26, 27 und einen Kondensator 30 gebildet. Die dem Verbraucher 9 parallel geschaltete Diode 29 befreit die Regelgröße (Signal X) von negativen Gleichspannungskomponenten. Über das Zeitglied, bestehend aus Widerstand 26, 27 und Kondensator 30 wird das Ausgangssignal V der Rückführungsfunktion 16 dem Ausgangssignal der Koppelfunktion 12 (Signal T) überlagert und dem zweiten Eingang 15 zugeführt. Ebenso ist es möglich, statt des zweipoligen Widerstanes 20 ein dreipoliges Potentiometer vorzusehen, wobei die Signale Z und V an den Anschlüssen des Gesamtwiderstandes des Potentiometers angeschlossen sind und der Ausgangsanschluß (Signal T) durch den Mittelabgriff gebildet wird. Als Operationsverstärker kann z.B. der Typ LM 393 verwendet werden.

Die Funktionsweise der in Fig. 5 A gezeigten Schaltung wird nachfolgend beschrieben. In Fig. 5 B beschreibt das Impulsdiagramm "1" den Verlauf der Ausgangsspannung (Signal E) des Signalgebers bzw. der Führungsgröße (Signal W). Zur Vereinfachung wurde angenommen, daß sich das Ausgangssignal E linear ändert. Ferner wird angenommen, daß sich die Schaltung im AUS-Zustand und das bewegbare Element 4 des Signalgebers in einer Position befindet, bei der die Feldplatte 1 einen Restwiderstand aufweist. In dem Impulsdiagramm "1" weist das Ausgangssignal E daher einen geringen Wert auf, der durch den Restwiderstand der Feldplatte 1 hervorgerufen wird. Wird das Element 4 langsam weiterbewegt, steigt der Widerstand der Feldplattensensoreinheit 1 wie auch das Ausgangssignal E stetig an. Für den Zeitraum $t_0$ bis $t_1$ wird angenommen, daß die Referenzspannung (Signal F) größer ist als das Ausgangssignal E. Da das Signal E bis zu dem Zeitpunkt $t_1$ kleinere Werte als die Referenzspannung F annimt, liegt an dem Ausgang 33 die maximale Ausgangsspannung Z. Für den Zeitraum $t_0$ bis $t_1$ liegt somit auch der maximale Spannungswert des Signals Z an dem zweiten Anschluß 15 an, der größer ist, als die Spannung W am ersten Eingang. Folglich steht am Ausgang des zweiten Komparators 32 die volle Betriebsspannung (Signal Y) der Schaltungsanordnung, und der Transistor der Steuerfunktion 10 befindet sich im Sperrzustand, so daß kein Strom durch den Verbraucher 9 fließt.

Zum Zeitpunkt $t_1$ übersteigt das Signal E aufgrund entsprechender Positionierung des Elementes 4 das Referenzsignal F und der Spannungswert Z an dem Ausgangsanschluß 33 fällt auf den Wert Null (oder bei bipolarer Versorgungsspannung etwa auf den Wert der negativen Versorgungsspannung), so daß auch der Widerstand 20 der Koppelfunktion 12 auf diesen Wert gelegt wird und mit dem Widerstand 27 eine Parallelschaltung bildet.

Die Spannung an dem Kondensator 30 fällt im wesentlichen mit der aus den Widerständen 20, 27 und der Kapazität 30 resultierenden Zeitkonstanten auf niedrige Werte ab (Impulsdiagramm "4"), wobei der Einfluß des Verbrauchers 9 auf die Zeitkonstante in der Darstellung vernachlässigt ist. Durch das Absinken der Spannung am Kondensator 30 (Signal V) liegt nach kurzer Zeit die Situation vor, daß die Spannung an dem ersten Eingangsanschluß 14 wieder größere Werte als die Spannung an dem zweiten Eingangsanschluß 15 einnimmt und die Ausgangsspannung des zweiten Komparators 32 auf einen niedrigen Wert abfällt (Impulsdiagramm "5"; Zeitraum $t_1$ bis $t_2$). Der Transistor der Steuerfunktion 10 wird leitend, so daß ein Stromfluß durch den Verbraucher 9 erfolgt, was in Abhängigkeit der Betriebsgröße (z.B. Drehzahl eines Elektromotors als Verbraucher 9) zu dem Vorliegen eines Signals X und zu einer Aufladung des Kondensators 30 führt. Die Spannung am Kondensator 30 (Signal V) wächst wieder an, bis der Spannungwert zum Zeitpunkt $t_2$ erreicht ist, der über das bewegbare Element 4 vorgegeben wurde.

Übersteigt die Spannung des Kondensators 30 (Signal V) die Spannung am ersten Eingangsanschluß 14, schaltet der Komparator 32 ausgangsseitig sofort auf postive Betriebsspannungswerte. Der Transistor sperrt und die Drehzahl des Motors verringert sich kurzfristig. Die Spannung am Kondensator 30 fällt ab bis der Komparator 32 ausgangsseitig wieder auf niedrige Spannungswerte herunterschaltet, wenn die Spannung des Kondensators 30 zum Zeitpunkt $t_3$ den Spannungswert des Signals W am ersten Einganganschluß 14 des zweiten Komparators 32 wieder unterschreitet.

Wie in den Impulsdiagrammen "4", "5", "6" dargestellt ist, erfolgt die Drehzahlregelung des Motors durch Ein-und Ausschalten des Motors über unterschiedliche Impuls-Pausen-Verhältnisse, wobei dieses Verhältnis durch die Positionierung des Elements 4 vorgegeben wird. Dem Widerstand 20 kommt demnach bei der Entkoppelung des Regelkreises von der Schwellwertfunktion 7 im EIN-Zustand eine wesentliche Funktion zu, in dem Ausgang 33 dann auf etwa das Potential des Minus-Pols der Versorgungsspannung gelegt wird. Vorzugsweise weist der Widerstand 20 der Koppelstufe 12 einen Wert von 10 KOhm auf. Sinkt der Spannungwert des Signals E durch Zurückbewegen der Steuervorrichtung 4 unter den Wert des Signals F steigt die Spannung am Ausgang 33 auf einen Maximalwert, und der Transistor wird in zuvor beschriebener Weise gesperrt.

Die Schaltungsanordnung bildet zusammen mit dem manuell betätigbaren Signalgeber ein Stell- und Regelsystem für mindestens eine Betriebsgröße eines elektrsichen Gerätes. Andererseits stellt der Signalgeber eine Schnittstelle zwischen einem mechanischen System und einem elektrischen System dar, d.h. er setzt eine Kraftwirkung, die z.B. von einem Finger auf das bewegbare Element 4 ausgeübt wird, in eine elektrische, von der Schaltungsanordnung auswertbare Größe um.

Nachfolgend werden bevorzugte Ausgestaltungen des mechanischen Aufbaus des Signalgebers beschrieben, die mit der beschriebenen Schaltungsanordnung in äußerst vorteilhafter Weise zusammenwirken.

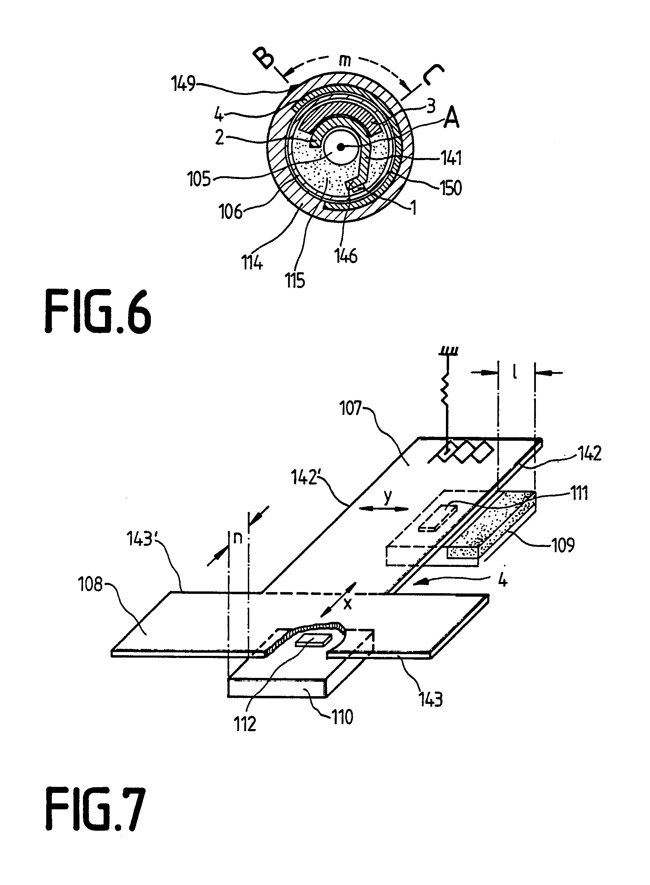

Fig. 6 zeigt einen Querschnitt durch ein erstes Ausführungsbeispiel eines vorzugsweise manuell betätigbaren Signalgebers für ein ELektrogerät mit einer stabförmigen Grundform. Der Signalgeber dient zum Einstellen mindestens einer Betriebsgröße, z.B. der Drehzahl eines Elektromotors eines elektrischen Gerätes. Bei dem stabförmigen Elektrogerät kann es sich beispielsweise um eine elektrische Zahnbürste oder um eine Munddusche oder ähnliches handeln. Im Zentrum des punktiert dargestellten Gehäuseschaftkörpers 115 ist eine rohrförmige Aussparung 105 vorgesehen, die zur Aufnahme von zum Beispiel strom-und wasserführunden Leitungen dienen kann. Der stabförmige Gehäuseschaftkörper 115 erstreckt sich entlang einer Längsachse A, die in Fig. 6 in einem Mittelpunkt der Aussparung 105 als Punkt dargestellt ist.

In Ausnehmungen des Gehäuseschaftkörpers 115 sind der Permanentmagnet 3 und der Polschuh 2, der aus Weicheisenmaterial besteht, eingelagert. Der Permanentmagnet 3 und der Polschuh 2 sind als Zylinderschalensegmente ausgebildet und als hintereinandergeschichtete Kreisringabschnitte in der Figur zu erkennen. An dem Polschuh 2 ist an einer Längskante ein armförmiger Winkelabschnitt 141 angeformt, dessen fußförmiges freies Ende 146 ein auf elektrische oder magnetische Felder empfindliches Element trägt, das die Position des bewegbaren Elements 4 detektiert und vorzugsweise als Feldplatte ausgebildet ist. Der armförmige Winkelabschnitt 141 erstreckt sich in etwa radial zur Längsachse A und ist derart bemessen, daß die Feldplatte 1 am Rand des Gehäuseschaftkörpers 115 angeordnet ist.

Das fußförmige freie Ende 146 endet in einem Bereich des Gehäuseschaftkörpers 115, der in etwa in dem Permanentmagneten 3 gegenüberliegt und von diesem nicht beansprucht wird. Daneben ist die Lage der Feldplatte 1 so gewählt, daß sie sich im Stellbereich des gleichfalls als Zylinderschalensegment ausgebildeten Elements 4 befindet, das in einem Stellhülsenzylinder 114 eingelagert und mit diesem um die Längsachse A drehbar ist.

Das Element 4, das aus Weicheisenmaterial oder aus einem Permanentmagneten besteht, ist über den Bogenbereich bzw. Stellung "m" zwischen den Punkten B und C zusammen mit dem Stellhülsenzylinder 114 verdrehbar, wobei die jeweilige Position durch eine Markierung 149 angezeigt wird. Die Bogenlänge und die Lage der Feldplatte ist so bemessen, daß die Feldplatte 1 von dem Element 4 unabhängig davon überdeckt wird, ob sich die Markierung 149 an dem Endpunkt B oder dem Endpunkt C befindet. Die Zylinderschalensegmente des Polschuhs 2 des Permanentmagneten 3 und des Elements 4 mit dem Stellhülsenzylinder 114 sind an die Gehäuseform bzw. Gehäusekrümmung des Elektrogerätes angepaßt, wobei der Polschuh 2 das innerste Schalensegment, der Permanentmagnet 3 das mittlere Schalensegment und das Element 4 das äußere Schalensegment bildet.

Die stationären Teile (115, 1, 2, 141, 146, 3) lassen sich als innere Teile bezeichnen, die durch eine Abdichtschicht, beispeilsweise ein Gehäuse 106 des elektrischen Gerätes hermetisch gegen äußere Umwelteinflüsse abdichtbar sind. Die Abdichtschicht bzw. das Gehäuse 106 verhindert das Eindringen von Wasser und Feuchtigkeit und gewährleistet eine sichere Funktion der inneren Bauteile einschließlich der Schaltungsanordnung und einen Schutz des Benutzers vor elektrischen Unfällen. Zwischen den inneren und äußren Teilen ist ein geringer Luftspalt 150 ausgebildet, der ein spielfreies und feinfühliges Gleiten des Stellhülsenzylinders 114 auf dem Gehäuse 106 erlaubt.

Die Funktionsweise der erfindungsgemäßen Stellvorrichtung besteht darin, daß durch das Element 4 der von dem Permanentmagneten 3 ausgehende Streufluß 5 (vgl. Fig. 1) verändert wird. Wie zuvor beschrieben, ist die Feldplatte 1 im Überlappungbereich der einen Längskante des Elements 4 angeordnet. Andererseits befindet sich der Permanentmagnet 3 im Überlappungsbereich der anderen Längskante des Elements 4. In Fig. 6 ist zu erkennen, daß der Permanentmagnet 3 durch die gezeigte Lage des Stellhülsenzylinders 114 mit der Markierung 149 im Punkt B weitestgehend überdeckt wird. Mit der Drehung des Stellhülsenzylinders 114 im Uhrzeigersinn gelangt die Markierung 149 zusammen mit dem Element 4 zu dem Punkt C. Mit fortschreitender Drehung verringert sich der Überdeckungsgrad des Elements 4 und des Permanentmagneten 3.

Vorzugsweise erstreckt sich die Magnetisierungsrichtung des Permanentmagneten 3 in radialer Richtung, so daß der magnetische Kreis der von dem Permanentmagneten 3 erzeugten magnetischen Induktion wie folgt verläuft: Von der Oberte des Permanentmagneten 3 erstrecken sich die magnetischen Feldlinien des Streuflusses zu dem Element 4 und verlaufen hier wegen der hohen Permeabilität des Materials bevorzugt durch das Element 4. An dem anderen freien Ende des Elements 4 treten die Feldlinien über die Feldplatte 1 in das fußförmige Ende 146 des Polschuhes 2 ein. Anschließend verlaufen die Feldlinien von dem Winkelabschnitt 141 zu dem schalenförmigen Polschuh 2 und von dort zu dem Permanentmagnet 3. Um die magnetischen Widerstände klein zu halten, ist die Abdichtschicht bzw. das Gehäuse 106 sowie der Luftspalt 150 zwischen dem Permanentmagneten 3 und dem Element 4 und der Abstand von dem Element 4 zu der Feldplatte 1 möglichst gering zu halten. Ebenso liegt der Permanentmagnet 3 mit seiner Innenseite möglichst ohne Luftspalt auf der Außenseite des Polschuhes 2 auf.

Infolge des unterschiedlichen Überlappungbereichs des Elements 4 und des Permanentmagneten 3 ändert sich die magnetische Induktion in Abhängigkeit von der relativen Lage des Elements 4 zu dem Permanentmagneten 3. Dementsprechend wird auch die Feldplatte 1 von einem größeren oder kleineren Streufluß 5 durchsetzt. Befindet sich die Markierung 149 am Anschlagplunkt B, wird die Feldplatte 1 von einem großen Magnetfluß durchströmt, weil der Überdeckungsgrad des Elements 4 und des Permanentmagneten 3 gleichfalls groß ist. Umgekehrt ist der Streufluß 5 duch die Feldplatte 1 am kleinsten, wenn sich die Markierung 149 an dem Anschlagpunkt C befindet. Die Feldplatte 1 besitzt die Eigenschaft, daß sich ihr Widerstand in Abhängigkeit des sie durchsetzenden Flußes ändert. Diese Widerstandsänderung wird durch die zuvor beschriebene Auswerteschaltung zur Steuerung einer Betriebsgröße des Elektrogerätes herangezogen. Mittels des Stellhülsenzylinders 114 läßt sich so beispielsweise die Motordrehzahl einer elektrischen Zahnbürste von der höchsten Drehzahl im Punkt B kontinuierlich zwischen der niedrigsten Drehzahl im Punkt C regeln oder steuern. Je nach Auslegung der Auswerteschaltung kann die höchste Motordrehzahl aber auch im Punkt C liegen.

Eine kontinuierliche Variation der Betriebsgröße eines Elektrogerätes läßt sich mit dem Signalgeber aus Fig. 6 durch Verdrehen des Stellhülsenzylinders 114 um die Längsachse A durchführen. Das beschriebene Ausführungsbeispiel läßt sich jedoch auch so abwandeln, daß eine Variation der Betriebsgröße allein durch Verschieben des Stellhülsenzylinders 114 parallel zu der Längsachse A erfolgt. Hierzu ist es erforderlich, den Streufluß bzw. den Überlappungsgrad des Elements 4 und des Permanentmagneten 3 durch Verschieben längs der Längsachse A zu variieren.

In vorteilhafter Weise ist der Signalgeber derartig abwandelbar, daß im Stellhülsenzylinder 114 lediglich die Feldplatte 1 und der Polschuh 2 mit dem Winkelabschnitt 141 und dessen fußförmigen freien Ende 146 angeordnet ist, während der Permanentmagnet 3 das bewegbare Element 4, welches im Stellhülsenzylinder 114 eingebettet ist, bildet.

Eine weitere vorteilhafte Ausgestaltung mit einem Minimum an Teilen wird dadurch gebildet, daß als bewegbares Element 4 ein Permanentmagnet vorgesehen ist, der über seine Ausdehnung in Drehrichtung einen Magnetfeldgradienten aufweist. In diesem Fall kann sogar auf den Polschuh 2 verzichtet werden, lediglich die Feldplatte 1 ist im Innenraum des Gerätegehäuses anzuordnen. Ein Verdrehen eines solchermaßen ausgestalteten Elements 4 bewirkt für jede Einstellung einen anderen, die Feldplatte 1 durchsetzenden Fluß, so daß über unterschiedliche Eisntellungen des bewegbaren Elements 4 unterschiedliche Widerstandswerte der Feldplatte 1 einstellbar sind und eine Steuerung oder Regelung einer Betriebsgröße des elektrischen Gerätes auf die bereits beschriebene Art und Weise möglich ist.

Unter Fig. 6 wurde ein Signalgeber beschrieben, der jeweils eine Veränderung einer Betriebsgröße erlaubt. Es ist zwar möglich, mittels zwei Feldplatten den Signalgeber so auszugestalten, daß zwei Betriebsgrößen des Elektrogerätes variiert sind, wobei Flußänderungen über eine Verschiebung eines ersten bewegbaren Elements 4 in Richtung Längsachse A und über eine Verdrehung eines zweiten bewegbaren Elements 4 um die Längsachse A bei geeigneter An-ordnung zweier Feldplatten erfolgen könnten. Jedoch besteht hier die Gefahr, daß sich die beiden Flüsse derart ungünstig gegensei-tig beeinflussen, daß eine unabhängige Variation der beiden Be-triebsgrößen nicht möglich ist.

In Fig. 7 ist ein weiteres. Ausführungsbeispiel des Signalgebers dargestellt, mit dem zwei Betriebsgrößen des Elektrogerätes sicher und unabhängig voneinander einstellbar sind. Das bewegbare Element 4 des eben ausgebildeten Signalgebers weist eine T-förmige Grundform mit einem Längsabschnitt 107 une einem Querabschnitt 108 auf. Der Längsabschnitt 107 besitzt zwei Längskanten 142 und 142′, und der Querabschnitt 108 zwei Querkanten 143 und 143′, wobei die Querkante 143′ im Anschlußbereich des Längsabschnittes 107 in die Längskanten 142, 142′ übergeht. Im Bereich der Längskante 142 des Längsabschnittes 107 ist eine Permanentmagnet-Polschuheinheit 109 angeordnet. Die verwendeten feldempfindlichen Elemente sind mit Feldplatte 111 und Feldplatte 112 bezeichnet, wobei die Permanentmagnet-Polschuheinheit 109 die Feldplatte 111 trägt. In gleicher Weise ist eine zweite Permanentmagnet-Polschuheinheit 110 mit der zweiten Feldplatte 112 im Bereich der Querkante 143 des Querabschnitts der Steuervorrichtung 4 aufgebaut. In der Permanentmagnet-Polschuheinheit 109 ist der Permanentmagnet punktiert dargestellt.

Durch die Anordnung der Sensoreinheiten an unterschiedlichen Kanten des Elements 4 und die T-förmige Form des Elements 4 wird vermieden, daß sich die beiden Streuflüsse gegenseitig störend beeinflussen. Ein Verschieben des bewegbaren Elements 4 in Y-Richtung ändert den die Feldplatte 111 durchsetzenden magnetischen Fluß, während eine Verschiebung in X-Richtung zu einer Änderung des die Feldplatte 112 durchsetzenden magnetischen Flusses führt. Der Vorteil des erläuterten Signalgebers besteht darin, daß der Überlappungsgrad z.B. zwischen dem bewegbaren Element 4 im Bereich der Querkante 143 und der Permanentmagnet-Polschuheinheit 110 nicht verändert wird, wenn das Element 4 in Y-Richtung bewegt wird. Gleiches gilt umgekehrt, wenn das Element 4 in X-Richtung verschoben wird. Wenn beispielsweise auf dem Längsabschnitt 107 längs verlaufende, schematische angedeutete Rastkerben vorhanden sind, die parallel zueinander und zu der Längskante 142 verlaufen, läßt sich das Element 4 in Y-Richtung stufenweise von einer Rastkerbe zur nächsten verschieben, wobei eine Feder einen Rasthebel in die jeweilige Rastkerbe drückt. Andererseits ist es möglich, die Steuervorrichtung 4 entlang der X-Richtung kontinuierlich zu verschieben. Die über die Feldplatte 112 veränderbare zweite Betriebsgröße läßt sich so auch mechanisch kontinuierlich und unabhängig von der ersten Betriebsgröße einstellen, die durch die erste Feldplatte 111 und die gewählte Rastkerbe bestimmt wird. Gegebenenfalls ist es auch möglich, für die X-Richtung entsprechende Rastkerben vorzusehen, die rechtwinklig zu den zu der Y-Richtung zugehörigen Rastkerben verlaufen.

Das bewegbare Element 4 ist aus einem einzigen Blechstück gefertigt, das eine T-Form aufweist. Andererseits ist es unter Beibehaltung der zuvor beschriebenen Vorteile möglich, das Element 4 L-förmig auszubilden oder in einer T-oder L-Grundform aus zwei getrennt voneinander gefertigten Teilen, die den Längsabschnitt 107 und den Querabschnitt 108 bilden, herzustellen, in dem beide Teile beispielsweise überlappend miteinander vernietet sind. Gegebenenfalls ist es auch vorteilhaft, den Querabschnitt 107 über ein magnetisch nicht aktives Isolierstück mit dem Querabschnitt 1o8 zu verbinden, wodurch die magnetische Entkopplung zwischen den beiden Streuflüssen zusätzlich erhöht wird. Weiter ist in einer anderen Ausführungsform vorgesehen, einen zweiten Querabschnitt 108 an dem freien Ende des Längsabschnittes 107 auzubringen, so daß das Element 4 eine H-förmige Grundform aufweist. Auch können an den anderen verbleibenden freien Kanten der Längs-oder Querabschnitte 107, 108 weitere Feldplatten mit Permanentmagnet-Polschuhen vorgesehen sein, die zur Erhöhung der Empfindlichkeit des Signalgebers den Feldplatten 111, 112 in geeigneter Weise zugeschaltet werden. Obwohl in den Ausführungsbeispielen ein auf magnetische Flußänderungen empfindlicher Signalgeber beschrieben ist, liegt es im Rahmen der Erfindung, auf elektrische Feldände4rungen empfindliche, kapazitiv wirkende Signalgeber einzusetzen. Insbesondere ist es auch möglich, andere Sensorprinzipien - z. B. Hallsonden oder auf elektromagnetische Wechselfelder empfindliche Sensoren, wie Schwingkreise - zusammen mit dem bewegbaren Element 4 zu verwenden.

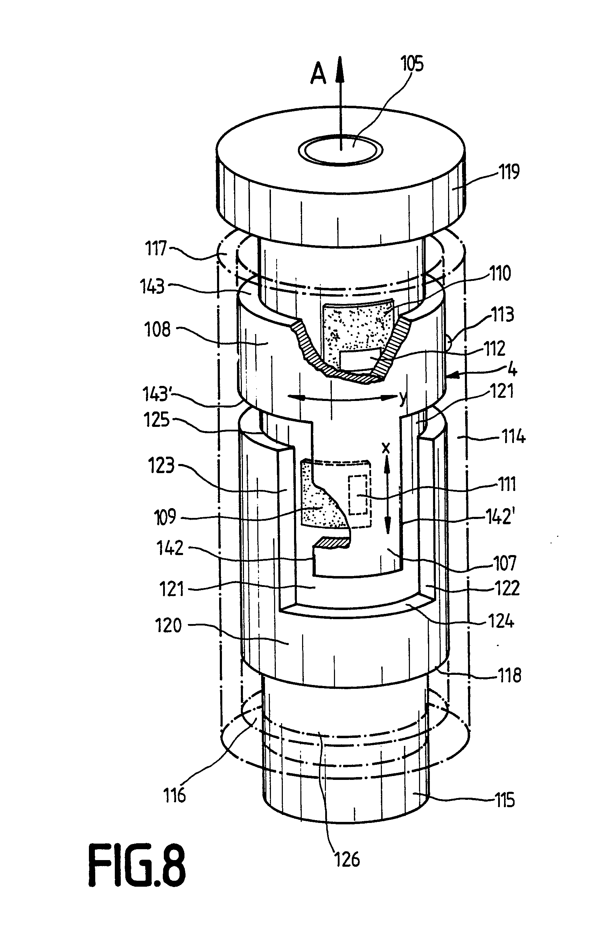

Fig. 8 zeigt in perspektivischer Ansicht ein weiteres Ausführungsbeispiel eines Signalgebers, bei dem eine sichere mechanische Führung des bewegbaren Elements 4 gegeben ist. Der Querabschnitt 108 ist ringförmig um die Längsachse A des stabförmigen Gehäuseschaftkörpers gebogen, wobei sich der Längsabschnitt 107 parallel zu der Längsachse A erstreckt. Hierzu ist der Längsabschnitt 107 über seine Breite gleichfalls an die Oberflächenkrümmung des Gehäuseschaftkörpers 115 angepaßt. Damit läßt sich das an die Oberflächenkrümmung des Gehäuseschaftkörpers 115 angepaßte Element 4 leicht durch Drehbewegungen in Y-Richtung und durch Längsverschiebungsbewegungen in X-Richtung verstellen. Der Gehäuseschaftkörper 115 trägt somit wesentlich zur mechanischen Führung der Steuervorrichtung 4 bei, wobei die ringförmige Verklammerung durch den Querabschnitt 108 schon allein ausreicht, das Element 4 sicher auf dem Gehäuseschaftkörper 115 zu befestigen. Ist der Stellhülsenzylinder 114 gleichfalls als voll um den Gehäuseschaft 115 umlaufender, strichpunktiert dargestellter Ring ausgebildet, ist es nicht erforderlich, daß sich der Querabschnitt 108 zur sicheren Halterung über die Hälfte der Oberfläche des Gehäuseschaftkörpers 115 hinaus erstreckt. Das Element 4 läßt · sich so zusammen mit dem Stellhülsenzylinder 114 auf dem Gehäuseschaftkörper 115 verschieben und verdrehen, wobei z.B. ein Vorsprung 113 am Element 4 dazu beitragen kann, daß der Stellhülsenzylinder 114 sicher mit dem Element 4 verankert ist. Die Drehachse des Elements 4 bzw. des Stellhülsenzylinders 114 fällt mit der Längsachse A des Gehäuseschaftkörpers 115 zusammen. Jedoch läßt sich der Vorteil der mechanischen Führung durch Anpassen des Elements 4 an die Krümmung der Oberfläche des Gehäuseschaftkörpers 115 auch bei anderen Geräten erzielen, die beispielsweise einen breiten Handgriff aufweisen und an einer Vorderkante abgerundet sind. In diesem Fall fällt die Drehachse der Steuervorrichtung 4 nicht mit der Längsachse des Gehäuseschaftkörpers zusammen und der Stellhülsenzylinder 114 ist nicht als geschlossener Ring, sondern als Zylindersegment ausgebildet. Ein derartiges Ausführungsbeispiel der Stellvorrichtung nach der Erfindung mit einem Stellhülsenzylinder in Form eines Zylinderschalensegmentes läßt sich beispielsweise im Handgriff eines Haartrockners unterbringen, der keinen runden Gehäuseschaftkörper 115 aufweist. Der Gehäuseschaftkörper 115 weist ein Oberteil 119 auf, das beispielsweise nach Aufschieben des Elements 4 auf den Gehäuseschaftkörper 115 aufgesetzt wird und als Anschlag für die obere Anschlagkante 117 des Stellhülsenzylinders 114 bzw. die Querkante 143 des Querabschnitts 108 in Ringform dient. Zusätzlich ist auf dem Gehäuseschaftkörper 115 eine Anschlaghülse 120 mit einer Aussparung 121 zur Aufnahme des Längsabschnitts 107 und mit Anschlagkanten 118, 122 bis 125 vorgesehen. Die Aussparung 121 bildet gleichzeitig ein Bewegungsfeld für den Längsabschnitt 107 des Elements 4. Der Stellhülsenzylinder 114 weist einen inneren Durchmesser auf, der dem Außendurchmesser der Anschlaghülse 120 entspricht, wobei der Stellhülsenzylinder 114 beispeilsweise von unten auf den Signalgeber aufgeschoben und mit dem Element 4 verbunden wird. Vorzugsweise weist der Außendurchmesser der Anschlaghülse 120 den gleichen Ringdurchmesser auf wie der Querabschnitt 108. Die Längsbewegung des Stellhülsenzylinders 114 wird beispielsweise in Richtung der Längsachse A durch die Anschlagskanten 116 und 118 bzw. 117 und Oberteil 119 bzw. 143 und 125 begrenzt. Die Drehbewegung des Elements 4 wird nach links durch die Anschlagkante 123 der Aussparung 121 und die Längskante 142 bzw. nach rechts durch die Anschlagkante 122 der Aussparung 121 und die Längskante 142' des Längsabschnittes 107 begrenzt, der zapfenförmig in die Aussparung 121 ragt. Die Permanentmagnet-Polschuheinheiten 109, 110 mit den Feldplatten 111, 112 sind in entsprechenden Aussparungen in dem Gehäuseschaftkörper 115 angeordnet. Beispielsweise können die elektrischen Leitungen zu den Feldplatten 111, 112 in der rohrförmigen Aussparung 105 des Gehäuseschaftkörpers 115 verlaufen. Weiter ist es in sehr vorteilhafter Ausgestaltung möglich, daß das Innere des Gehäuseschaftkörpers 115 mit den Feldplatten 111, 112 durch die in Fig. 6 dargestellte geschlossene Abdichtschicht 106 oder das Gerätegehäuse gegen das Eindringen von Feuchtigkeit und Flüssigkeit abgeschlossen ist. Dazu ist die in Fig. 8 nicht gezeigte Abdichtschicht 106 in geeigneter Weise an die Aussparung 121 bzw. die Anschlaghülse 120 anzupassen. Der für eine leichte Bewegung des Stellhülsenzylinders 115 erforderliche geringe Luftspalt 150 ist in Fig. 8 nicht dargestellt.

Das Element 4 ist in Verbindung mit dem Stellhülsenzylinder 114 innerhalb der vorgegebenen Freiheitsgrade beliebig innerhalb des Bewegungsfeldes verstellbar. Dieses Bewegungsfeld wird durch die zuvor beschriebenen Anschlagkanten definiert. Damit läßt sich die erste Betriebsgröße des Elektrogerätes durch eine Linearbewegung in X-Richtung bzw. Längsachsenrichtung (A) und die zweite Betriebsgröße durch eine Drehbewegung in Y-Richtung bzw. um die Längsachse A verstellen. Zwar können auch entsprechende Rastmittel vorgesehen werden, die ein schrittweises Bewegen des Elements 4 in X-oder Y-Richtung erlauben. Dennoch erweist es sich in den meisten Anwendungsfällen als besonders vorteilhaft, eine kontinuierliche Einstellbarkeit vorzusehen. Das Element 4 läßt sich dann innerhalb des durch die Anschlagkanten begrenzten Bewegungsfeldes auf beliebigen Bahnkurven äußerst feinfühlig bewegen, wobei die Steuerung oder Regelung der beiden veränderbaren Betriebsgrößen ohne irgendeine körperliche Verbindung zum Gehäuseinnenraum erfolgt. Zum Einstellen der Betriebsgrößen ist nur die Reibung zwischen den stationären und beweglichen Teilen zu überwinden. Wird die Stellvorrichtung nach Fig. 8 beispielsweise in einer elektrischen Zahnbürste verwendet, die gleichzeitig über den Bürstenkopf eine Wasserzufuhr zuläßt, läßt sich z. B. die Drehbewegung der Zahnbürste durch die Drehbewegung des Stellhülsenzylinders und die Wasserzufuhr durch die Linearbewegung variieren. Ebenso ist es möglich, die Betätigungseinrichtung bzw. den Signalgeber beispeilsweise in einem Haartrockner einzusetzen, bei dem mit der Drehbewegung die Heizleistung und mit der Linearbewegung der Luftdurchsatz auf gewünschte Werte eingestellt wird. Der Benutzer eines solchermaßen ausgestatteten Elektrogerätes kann so leicht und schnell gleichzeitig zwei Betriebsgrößen des Gerätes manuell in gewünschter Weise variieren, wobei dennoch das Gerätegehäuse hermetisch abgeschlossen und gegen Wasser-bzw. Staubeintritt geschützt sein kann.

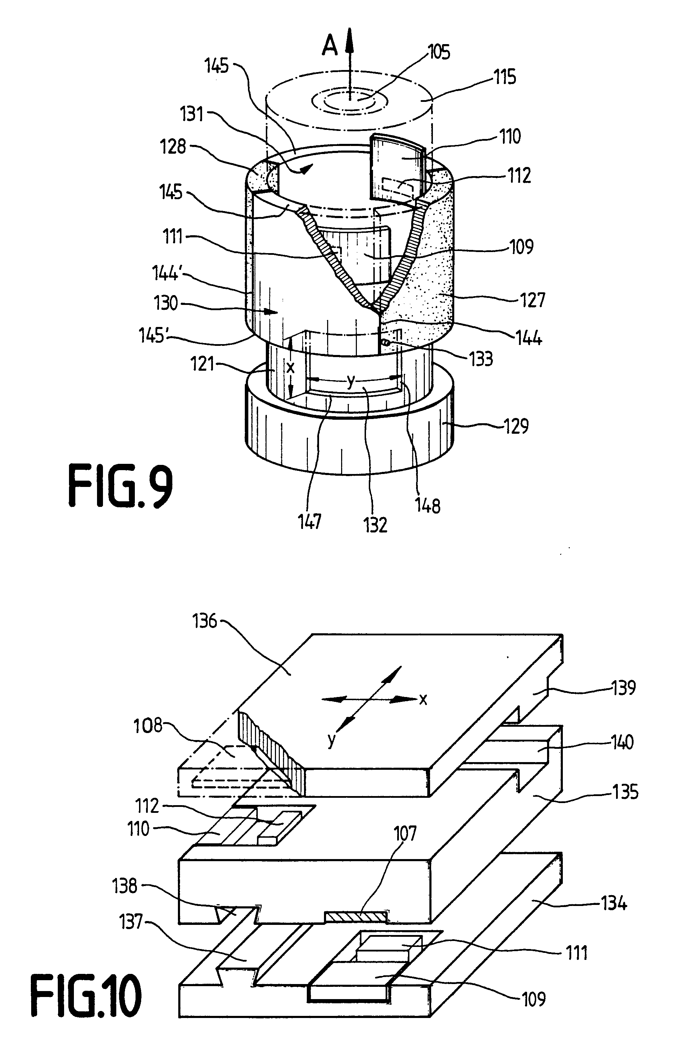

Fig. 9 zeigt ein weiteres Ausführungsbeispiel eines Signalgebers zum Ändern von zwei Betriebsgrößen. Abweichend von dem Ausführungsbeispiel der Fig. 8 weist der Signalgeber zwei voneinander getrennte bewegbare Elemente in Form von Zylinderschalenabschnitten 130, 131 auf, die über zwei magnetisch inaktive Isolierstücke 127, 128 zu einem Ring zusammengesetzt werden. Zur besseren Unterscheidung sind die Isolierstücke 127, 128 punktiert dargestellt. Im unteren Bereich des Gehäuseschaftkörpers 115 ist ein Unterteil 129 angeordnet. Ein Bewegungsfeld ist mit dem Bezugszeichen 132 bezeichnet und als zylinderschalenförmige Aussparung in dem Gehäuseschaftkörper 115 ausgebildet. Die Löngsbewegung der Zylinderschalenabschnitte 130, 131 wird in X-Richtung durch die Anschlagkanten 147 und die Drehbewegung in Y-Richtung durch die Anschlagkanten 148 begrenzt, wobei die Anschlagkanten mit einem Anschlagstift 133 in Berührung kommen, der in das Bewegungsfeld 132 ragt und im Isolierstück 127 befestigt ist. Der Anschlagstift 133 kann jedoch an jeder anderen geeigneten Stelle vorhanden sein. Der Ring, der aus den zwei magnetisch aktiven Zylinderschalenabschnitten 130, 131 und den zwei magnetisch inaktiven Isolierstücken 127, 128 besteht, kann so entsprechend der Größe des Bewegungsfeldes 132 durch Dreh-oder Linearbewegungen verstellt werden.

Zur Varition der beiden Betriebsgrößen sind zwei Permanentmagnet-Polschuheinheiten 109, 110 vorgesehen. Die Feldplatte 111 und die zugehörige Permanentmagnet-Polschuheinheit 109 sind an der Seitenlängskante 144 des Zylinderschalenabschnittes 130 angeordnet. Ebenso ist die zweite Feldplatte 112 mit der zugehörigen Permanentmagnet-Polschuheinheit 110 im Bereich der Ringkante 145 des zweiten Zylinderschalenabschnittes 131 angeordnet. Durch die beiden Isolierstücke 127, 128 wird verhindert, daß sich die beiden Streuflüsse für die erste und zweite Feldplatte 110, 111 gegenei nander störend beeinflussen. Abweichend von dem in Fig. 9 gezeigten Ausführungsbeispiel kann vorteilhaft vorgesehen werden, die beiden magnetisch aktiven Zylinderschalenabschnitte 130, 131 mit den zugehörigen Sensoreinheiten 109 bis 112 an verschiedenen Stellen auf dem Umfang der Stellvorrichtung anzuordnen. Beispielsweise ist es in diesem Fall möglich, die beiden Zylinderschalenabschnitte 130, 131 längs der Längsachse A untereinander mit einem Abstand anzuordnen.

Es liegen auch andere Ausgestaltungen der beiden getrennten Zylinderschalenabschnitte 130, 131 im Rahmen der Erfindung, bei denen die Zylinderschalenabschnitte 130, 131 zusammen mit den Isolierstücken 127, 128 nicht zu einem Ring zusammengesetzt wird. Damit bietet die in Fig. 9 gezeigte Stellvorrichtung zahlreiche Anwendungsmöglichkeiten bei den verschiedensten Formen von Gehäuseschaftkörpern.

Fig. 10 zeigt ein letztes Ausführungsbeispiel eines Signalgebers, bei dem eine obere Schieberplatte 136, eine Zwischenplatte 135 und eine untere Schieberplatte 134 übereinander angeordnet sind. Zur mechanischen Führung der einzelnen Schieberplatten ist zwischen der oberen Schieberplatte 136 und der Zwischenplatte 135 eine Steg-/Nutverbindung 139, 140 vorgesehen, die eine Bewegung der oberen Schieberplatte 136 relativ zu der Zwischenplatte 135 entlang der X-Richtung erlaubt. Ebenso ist zwischen der Zwischenplatte 135 und der unteren Schieberplatte 134 eine Steg-/Nutverbindung 137, 138 vorgesehen, die senkrecht zu der Steg-/Nutverbindung 139, 140 verläuft. Mittels der Steg-/Nutverbindung 137, 138 ist die Zwischenplatte 135 zusammen mit der oberen Schieberplatte 139 entlang der Y-Richtung verschiebbar, wenn man annimmt, daß beispielsweise die untere Schieberplatte 134 fest mit dem Elektrogerät bzw. dessen Gehäuseschaftkörper verbunden ist. Im Gegensatz zu der oberen Steg-/Nutverbindung 139, 140 ist die untere Steg-/Nutverbindung 137, 138 als Schwalbenschwanz-Nutverbindung ausgebildet, die den Vorteil bietet, daß die Zwischenplatte 135 und die untere Schieberplatte 134 nicht mehr voneinander abhebbar sind, wie dies zwischen der oberen Schieberplatte 139 und der Zwischenplatte 135 möglich ist. Dadurch, daß die Steg-/Nutverbindungen 139, 140 und 137, 138 rechtwinklig zueinander verlaufen, ergibt sich der Vorteil, daß die Lage der oberen Schieberplatte 139 zu der Zwischenplatte 135 in X-Richtung verändert werden kann, ohne daß sich die Lage zwischen der Zwischenplatte 135 und der unteren Schieberplatte 134 ändert. Ebenso ist die Lage zwischen der oberen Schieberplatte 139 und der Zwischenplatte 135 nicht veränderbar, wenn die Zwischenplatte 135 gegenüber der unteren Schieberplatte 134 in Y-Richtung verschoben wird.

In der Zwischenplatte 135 und in der oberen Schieberplatte 139 sind weichmagnetische Elemente vorgesehen, die mit dem zuvor beschriebenen Längsabschnitt 107 und dem Querabschnitt 108 vergleichbar sind. An der unteren Schieberplatte 134 sind die Permanentmagnet-Polschuheinheit 109 und eine erste Feldplatte 111 angeordnet, die in der gleichen, zuvor beschriebenen Weise mit dem Längsabschnitt 107 zusammenarbeiten und nicht näher dargestellt sind. Ebenso ist in der Zwischenplatte 135 die zeite Feldplatte 112 mit der zugehörigen Permanentmagnet-Polschuheinheit 110 vorgesehen, die mit dem Querabschnitt 108 in der oberen Schieberplatte 139 zusammenwirken. Hierbei ist es unerheblich, ob die Abschnitte 107, 108 in der Zwischenplatte 135 oder in den Schieberplatten 134, 136 oder in der dargestellten Weise angeordnet sind. Wesentlich ist nur, daß die beiden Signalgeber an zwei verschiedenen Kantenbereichen angeordnet sind, die rechtwinklig zueinander verlaufen und rechtwinklig zueinander verschiebbar sind. Nur so ist sichergestellt, daß die zuvor beschriebenen Überlappungsgrade durch die Abschnitte 107, 108 entsprechend den Richtungen X und Y veränderbar sind.

Bei dem in Fig. 10 gezeigten Ausführungsbeispiel besteht keine erhebliche Gefahr, daß sich die magnetischen Streuflüsse der beiden Sensoreinheiten störend gegeneinander beeinflussen, weil die Steuerwirkung im wesentlichen von den Kanten der Abschnitte 107, 108 ausgeht. Jedoch ist es auch möglich, in der Zwischenschicht 135 eine magnetische Abschirmung vorzusehen, die ein gegenseitiges störendes Beeinflussen der beiden Streuflüsse unterbindet. Die Schieberplatten 134, 136 und die Zwischenplatte 135 bestehen vorzugsweise aus Kunststoff oder aus einem nicht ferromagnetischen Material. Die in Fig. 10 gezeigte Ausführungsform eignet sich beispeilsweise für einen Rasierapparat, wobei in diesem Fall eine Sensoreinheit für eine Richtung ausreicht, wenn beispielsweise nur die Schnittgeschwindigkeit geändert werden soll. Ebenso eignet sich die in Fig. 10 gezeigte Ausführungform für Elektrogeräte in Standform, wobei die Betätigungseinrichtung an einer ebenen Fläche des Gerätes anbringbar ist. Jedoch ist es auch vorteilhaft, die Platten 134, 135 und 139 kreisbogenförmig zu krümmen, um sie an das gekrümmte Griffteil eines Gerätes anzupassen. Hierzu sind die drei Platten 134, 135 und 136 gleichfalls schalenförmig übereinander angeordnet, wobei eine Steg-/Nutverbindung parallel zu der gedachten Drehachse verläuft, und sich die andere Steg-/Nutverbindung kreisbogenförmig um die gedachte Drehachse erstreckt.

Obwohl in den beschriebenen Ausführungsbeispielen die bewegbaren Elemente aus weichmagnetischem Material bestehen sollen, ist es jedoch möglich, die bewegbaren Elemente selbst als Permanentmagnete auszubilden. Weiter ist es möglich, in allen Ausführungsbeispielen den Einsatz der Abdichtschicht anstelle oder zusammen mit dem Gehäuse vorzusehen. Ferner kann das Bewegungsfeld beispielsweise dreieckförmig ausgebildet sein. Statt der beschriebenen, induktiv wirkenden Sensoreinheit ist auch der Einsatz einer kapazitiv wirkenden Sensoreinhiet für verschiedene Anwendungsfälle vorteilhaft, wobei ein L-, T-oder H-förmiges Element 4 Anwendung finden kann.

## Ansprüche

1. Betätigungseinrichtung für ein elektrisches Gerät zum Steuern oder Regeln wenigstens einer Betriebsgröße des elektrischen Geräts mit einem Signalgeber zur Erzeugung von Steuergrößen, und einer Schaltungsanordnung mit wenigstens einem Ausgang und Eingang, dadurch gekennzeichnet, daß der Signalgeber ein bewegbares, an dem elektrischen Gerät angeordnetes Element (4), welches in Abhängigkeit von seiner Positionierung magnetische oder elektrische Felder unterschiedlicher Feldstärke bewirkt und ein, auf magnetische oder elektrische Felder empfindliches, stationär am elektrischen Gerät angeordnetes Element aufweist, das feldempfindliche Element eine Ausgangsgröße erzeugt, die ein Maß für die Feldstärke am Ort des feldempfindlichen Elements ist, die Ausgangsgröße der Schaltungsanordnung zuführbar ist und die Schaltungsanordnug wenigstens eine Steuerschaltung beinhaltet, die ihrerseits die Betriebsgröße des elektrsichen Gerätes beeinflußt.

2. Betätigungseinrichtung nach Anspruch 1, dadurch gekennzeichnet, daß die Schaltungsanordnung eine Schwellwertfunktion (7) und/oder eine Proportionalfunktion (8) aufweist.

3. Betätigungseinrichtung nach Anspruch 2, dadurch gekennzeichnet, daß das bewegbare Element (4) als Permanentmagnet oder als Rückschlußbügel eines Permanentmagnets und das feldempfindliche Element als Feldplatte (1) ausgebildet ist.

4. Betätigungseinrichtung nach Anspruch 3, dadurch gekennzeichnet, daß die Feldplatte (1) und die Schaltungsanordnung im Innenraum eines Gehäuses des elektrischen Gerätes angeordnet sind und das bewegbare Element (4) im Außenbereich des Gehäuses gelagert ist.

5. Betätigungseinrichtung nach einem der vorhergehenden Ansprüche, dadurch gekennzeichnet, daß die Schwellwertfunktion (7) als Ausgangssignal (Z) ein Ein-/Aus-Signal für die Betriebsgröße und die Proportionalfunktion (8) als Ausgangssignal (W) eine Stell-bzw. Führungsgröße der Betriebsgröße bildet und die Steuerschaltung die Betriebsgröße entsprechend den Ausgangssignalen (Z, W) einstellt.

6. Betätigungseinrichtung nach Anspruch 5, dadurch gekennzeichnet, daß die Steuerschaltung eine mit dem Ausgangssignal (W) beaufschlagte Steuerfunktion (10) und eine mit dem Ausgangssignal (Z) beaufschlagte Schaltfunktion (11) aufweist.

7. Betätigungseinrichtung nach Anspruch 6, dadurch gekennzeichnet, daß die Steuerfunktion (10) und die Schaltfunktion (11) in Serie geschaltet sind.

8. Betätigungseinrichtung nach Anspruch 5, dadurch gekennzeichnet, daß einer Steuerfunktion (10) das Ausgangssignal (Z) und das Ausgangssignal (W) als Eingangssignale zugeführt werden.

9. Betätigungseinrichtung nach Anspruch 5, dadurch gekennzeichnet, daß eine Steuerfunktion (10), eine Rückführungsfunktion (16) und die Proportionalfunktion (8) in Serie geschaltet sind un einen Regler bilden, wobei ein Ausgangssignal (Y) der Proportionalfunktion (8) der Steuerfunktion (10) zuführbar ist und das Ausgangssignal (Z) der Schwellwertfunktion (7) mit einem Ausgangssignal (V) der Rückführungsfunktion (16) verkoppelt (Signal T) und des verkoppelte Signal (T) neben einem Ausgangssignal (E) des Signalgebers der Proportionalfunktion (8) zugeführt wird.

10. Betätigungseinrichtung nach Anspruch 9, dadurch gekennzeichnet, daß der Schwellwertfunktion (7) das Ausgangssignal (E) des Signalgebers und ein Referenzsignal (F) zugeführt wird.

11. Betätigungseinrichtung nach einem der Ansprüche 8 - 10, dadurch gekennzeichnet, daß eine vorzugsweise als Widerstand (20) ausgebildete Koppelfunktion (12) vorgesehen ist, deren erster Anschluß mit dem Ausgangssignal (Z) und deren zweiter Anschluß mit einem Ausgangssignal (V) der Rückführungsfunktion (16) beautschlagbar ist.

12. Betätigungseinrichtung nach einem der vorhergehenden Ansprüche, dadurch gekennzeichnet, daß der Signalgeber neben dem bewegbaren Element (4) einen Permanentmagneten (3) und eine Feldplatte (1) aufweist, die einen sie durchsetzenden Fluß (5) des Permanentmagneten (3) in ein Ausgangssignal (E) des Signalgebers umsetzt, wobei durch das bewegliche Element (4) der von der Feldplatte (1) detektierte Fluß (5) variierbar ist.

13. Betätigungseinrichtung nach Anspruch 1-4, dadurch gekennzeichnet, daß das feldempfindliche Element als eine auf einem Polschuh (2) eines Permanentmagneten (3) angeordnete Feldplatte (1) ausgebildet ist, wobei mittels des bewegbaren Elements (4) der die Feldplatte durchsetzende Fluß (5) variierbar ist und daß das Element (4), der Polschuh (2) und der Permanentmagnet (3) im wesentlichen Schalensegmente bilden, die konzentrisch um eine Achse (A) angeordnet sind.

14. Betätigungseinrichtung nach Anspruch 13, dadurch gekennzeichnet, daß der Polschuh (2) und der Permanentmagnet (3) im Inneren des Gerätegehäuses und das bewegbare Element (4) im Außenbereich des Gerätegehäuses angeordnet sind.

15. Betätigungseinrichtung nach Anspurch 13, dadurch gekennzeichnet, daß der Polschuh (2) und der Permanentmagnet (3) in einen stabförmigen Gehäuseschaftkörper (115) und das bewegbare Element (4) in einen äußeren Stell'senzylinder (114) eingelagert ist.

16. Betätigungseinrichtung nach Anspruch 15, dadurch gekennzeichnet, daß der Gehäuseschaftkörper (115) Anschlagkanten (122, 123, 124, 125) aufweist, die ein Bewegungsfeld (121) für das bewegliche Element (4) bilden.

17. Betätigungseinrichtung nach Anspruch 13, dadurch gekennzeichnet, daß der Polschuh (2) einen Winkelabschnitt (141) aufweist, an dessen freiem Ende (146) die Feldplatte (1, 111, 112) angebracht ist.

18. Betätigungseinrichtung nach Anspruch 12, dadurch gekennzeichnet, daß das bewegbare Element (4) aus einer Zwischenplatte (135) besteht, an deren Unterseite über eine Verzahnung (137, 138) eine untere Schieberplatte (134) mit einer ersten Feldplatte (111) und an deren Oberseite über eine Verzahnung (139, 140) eine obere Schieberplatte (136) mit einer zweiten Feldplatte (112) angeordnet ist, wobei die beiden Verzahnungen (137, 138, 139, 140) rechtwinklig zueinander verlaufen.

19. Betätigungseinrichtung nach Anspruch 2 oder 13, dadurch gekennzeichnet, daß das bewegbare Element (4) das äußere Teil des Signalgebers bildet und das innere Teil des Signalgebers durch eine flüssigkeits-bzw. feuchtigkeitsdichte Abdeckschicht (106) gegen äußere Einflüsse abgedichtet ist.

20. Betätigungseinrichtung nach einem der Ansprüche 1, 2, 3 oder 12 oder 13, gekennzeichnet durch ihre Verwendung bei einem oder mehreren der im folgenden aufgezählten Arten von elektrischen Kleingeräten: Zahnbürsten, Mundduschen, Haartrockner, Lockenstäbe, Rasierapparate, Küchenmaschinen, wie Foodprozessoren, Entsafter, Mixer, Chopper.

# FIG.1A

# FIG.1B

# FIG.2

FIG.3

FIG.4

FIG.5A

FIG.5B

FIG.6

FIG.7

FIG.8

FIG.9

FIG.10